Europäisches Patentamt

European Patent Office

Office européen des brevets

(19)

(11) Veröffentlichungsnummer : **0 127 693**
**B1**

(12) # EUROPÄISCHE PATENTSCHRIFT

(45) Veröffentlichungstag der Patentschrift :
09.09.87

(21) Anmeldenummer : 83105479.6

(22) Anmeldetag : 03.06.83

(51) Int. Cl.⁴ : **H 03 G  3/22**, H 03 F  1/54,
**H 03 G  3/30**

(54) **Verfahren zur automatischen Regelung der Ausgangsleistung eines Verstärkers.**

(43) Veröffentlichungstag der Anmeldung :
12.12.84 Patentblatt 84/50

(45) Bekanntmachung des Hinweises auf die Patenterteilung : 09.09.87 Patentblatt 87/37

(84) Benannte Vertragsstaaten :
DE FR IT

(56) Entgegenhaltungen :
DE-A- 3 036 613
DE-B- 1 298 201
FR-A- 2 401 510
FR-A- 2 482 800
FR-E-    74 801
US-A- 2 689 887
US-A- 2 752 430
US-A- 4 066 965
INTERNATIONAL CONFERENCE ON COMMUNICA-
TIONS, Conference Record Band 4, Session 70, 14.-
18. Juni 1981, Denver, Colorado, US, Seiten 70.3.1-
70.3.6; J.F. HENEY et al.:" High efficiency, KA-band,
traveling wave tube amplifiers for intersatelite links"

(73) Patentinhaber : ANT Nachrichtentechnik GmbH
Gerberstrasse 33
D-7150 Backnang (DE)

(72) Erfinder : Wassermann, Manfred, Dipl.-Ing.
Südstrasse 147
D-7150 Backnang (DE)
Erfinder : Lieblisch, Wolfgang, Dipl.-Phys.
Ludwigstrasse 11
D-7157 Sulzbach (DE)

(74) Vertreter : Schickle, Gerhard, Dipl.-Ing.
ANT Nachrichtentechnik GmbH Patent- und Lizenzabteilung Gerberstrasse 33
D-7150 Backnang (DE)

## Beschreibung

Die Erfindung betrifft ein Verfahren zur automatischen Regelung der Ausgangsleistung eines Hochfrequenzverstärkers gemäß Oberbegriff des Patentanspruchs 1 bzw. eine Schaltungsanordnung zur Durchführung dieses Verfahrens gemäß Oberbegriff des Anspruchs 2.

Ein solches Verfahren ist durch die FR-A-2 401 510 bekanntgeworden.

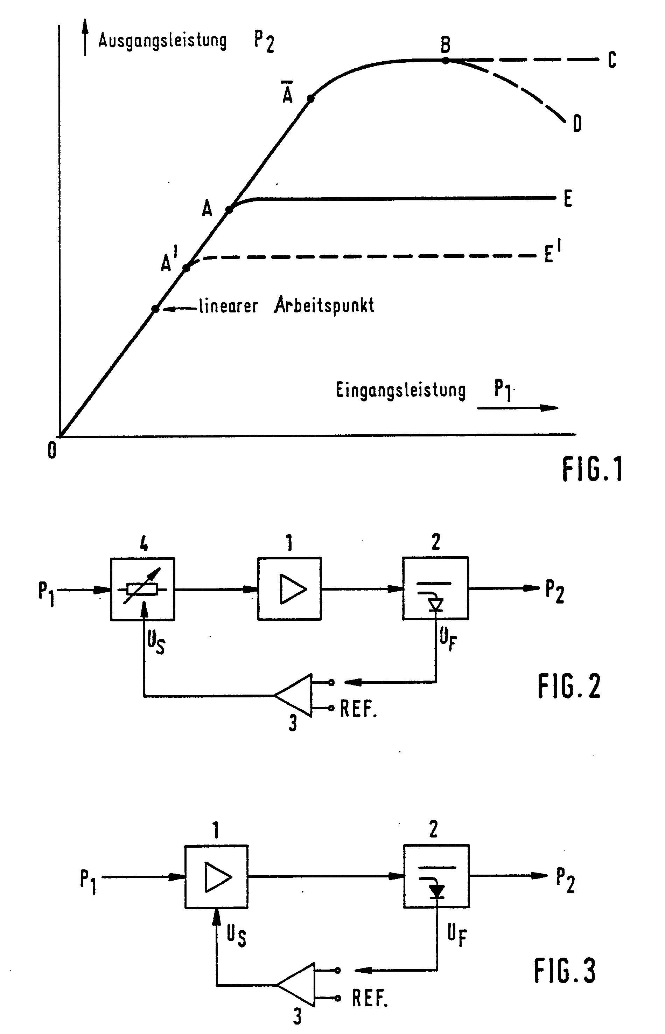

Bei Leistungsverstärkern zur Verstärkung von Hochfrequenzsignalen ist es wünschenswert, bei kleineren und mittleren HF-Leistungen im linearen Arbeitsbereich zu fahren und bei höherer HF-Ausgangsleistung dieselbe zu begrenzen, wobei der Leistungspegel, bei der die Begrenzung einsetzt, variabel sein sollte gemäß Kennlinienverläufe OAE bzw. OA'E' laut Figur 1. Durch Bereitsellung solcher Begrenzungskennlinien ergibt sich der Volteil, daß die Stromversorgungseinrichtung nur diejenige Leistung vorhalten muß, die dem Begrenzungswert AE der HF-Ausgangsleistung entspricht. Es ist allerdings notwendig, daß die Begrenzungskennlinien AE bzw. A'E' nur für mittlere Leistungen zu benutzen sind, d. h. für kurzzeitige Schwankungen der Eingangsleistung im unteren Frequenzbereich der Nachrichtensignale oder des hochfrequenten Trägers gilt nach wie vor die natürliche Kennlinie OABC bzw. OABD nach Figur 1. Diese Bedingung ist durch geeignete Bemessung der Regelzeitkonstante der entsprechenden Regeleinrichtung zu erfüllen.

Zur Erzielung der Begrenzungskennlinie sind verschiedene Schaltungsanordnungen bekannt, z. B. durch die US-A-2 689 887 und 4 066 965. In Figuren 2 und 3 sind zwei Schaltungs-Beispiele dargestellt. Die Figur 2 zeigt eine übliche ALC-Schaltung (Automatic Level Control), bei der ein Teil der vom Hochfrequenzverstärker 1 abgegebenen Ausgangsleistung im Koppler 2 Ausgekoppelt und gleichgerichtet wird ($U_F$), anschließend in einem Komparator 3 mit einem Referenzsignal REF verglichen, verstärkt und als Steuerspannung $U_S$ dem steuerbaren Dämpfungsglied 4 zugeführt wird. Dadurch wird die Amplitude des Eingangssignals $P_1$ des Hochfrequenzverstärkers 1 so beeinflußt, daß die Regelschleife die Ausgangsleistung $P_2$ auf einem konstanten Wert hält. Wird die Eingangsleistung $P_1$ kontinuierlich verkleinert, so wird im Kennlinienbereich AA' nach Figur 1 das Dämpfungsglied 4 nach Figur 2 seine minimale Dämpfung erreichen, wodurch die Regelschleife unterbrochen und der Betrieb des Verstärkers 1 nach der natürlichen Kennlinie OA'A verläuft.

Die Wirkungsweise der Schaltung nach Figur 3 ist ähnlich. Im Unterschied zu Figur 2 erfolgt hier die Regelung der Ausgangsleistung des Verstärkers 1 über eine Steuerelektrode unabhängig von der Eingangsleistung $P_1$.

Die bekannten Schaltungsanordnungen zur Erzielung der gewünschten Begrenzungskennlinien haben den Nachteil, daß zusätzliche Komponenten, vor allem Hochfrequenzbausteine, für den Regelkreis benötigt werden. Dies sind beispielsweise in Figur 2 das steuerbare Dämpfungsglied und der Koppler mit integriertem Gleichrichter. Hinzu kommen die HF-Durchgangsverluste des Kopplers.

Die Erfindung hat sich deshalb die Aufgabe gestellt, ein Verfahren bzw. eine Schaltungsanordnung zur Durchführung desselben anzugeben, wobei auf Hochfrequenzbausteine im Regelkreis verzichtet und der Regelungsaufwand reduziert werden kann.

Die Lösung erfolgt entsprechend für ein Verfahren und eine Schaltungsanordnung mit den in den Kennzeichen der Ansprüche 1 und 2 angegebenen Merkmalen.

Das erfindungsgemäße Verfahren und die Schaltungsanordnung zur Durchführung desselben weisen die Vorteile auf, daß teuere Hochfrequenzbausteine im Regelkreis vermieden werden und daß der Regelaufwand relativ klein ist.

Die Erfindung beruht auf der Erkenntnis, daß eine Abhängigkeit der HF-Ausgangsleistung von der durch die Stromversorgungseinrichtung abgegebenen Gleichstromleistung besteht, wobei die Abhängigkeit im wesentlichen proportionaler Art ist, und auf der Idee, ein von der abgegebenen Gleichstromleistung abgeleitetes Kriterium zur Regelung der HF-Ausgangsleistung zu benutzen.

Es folgt nun die Beschreibung der Figuren.

Die Figur 1 zeigt die Übertragungscharakteristik eines HF-Leistungsverstärkers mit den oben beschriebenen Arbeitskennlinien.

Die Figuren 2 und 3 stellen Schaltungsanordnungen zur Erzielung der Regelkennlinien nach dem Stand der Technik und wurden ebenfalls schon beschrieben.

Die Figur 4 zeigt das Blockschaltbild eines Wanderfeldröhrenverstärkers TWTA mit Stromversorgungseinrichtungen.

Die Figuren 5a und b stellen die mit der Schaltungsanordnung nach Figur 4 erzielbaren Kennlinien für die HF-Ausgangsleistung bzw. für die aufgenommenen Kollektorgleichstromleistung jeweils aufgetragen über der HF-Eingangsleistung $P_1$.

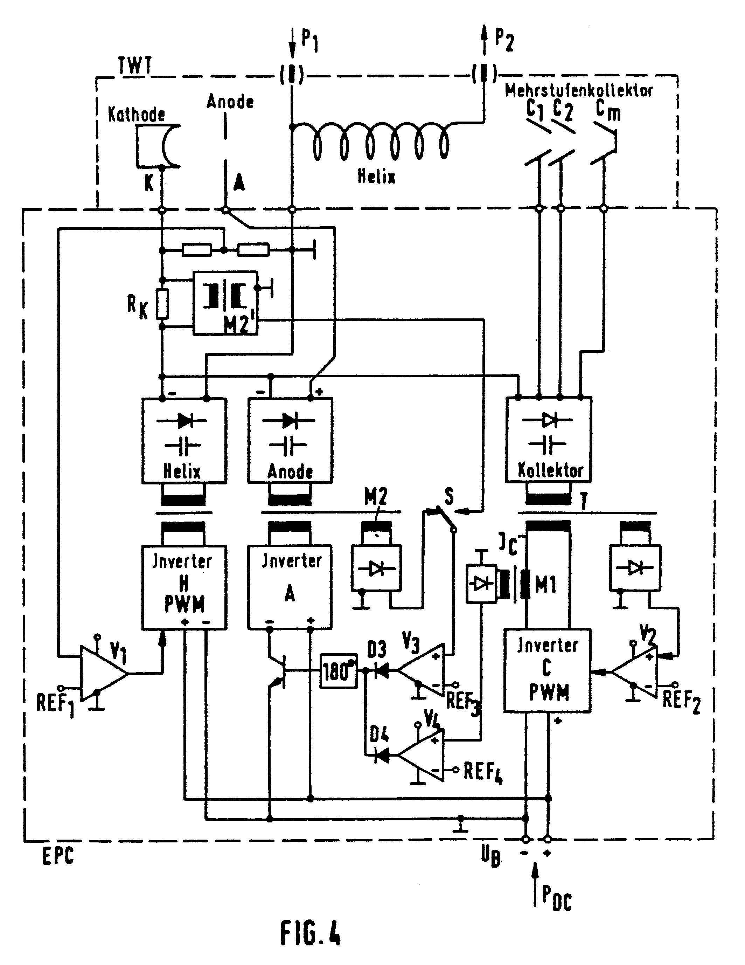

Der Obere Teil der Figur 4 zeigt eine symbolisch dargestellte Wanderfeldröhre TWT mit Kathode K, Anode A, Helix und den Kollektoren $C_1$ bis $C_m$, wobei üblicherweise $m \leqslant 5$ ist. Die darunter angeordnete Schaltungsanordnung EPC hat die Aufgabe, die genannten Elektroden mit den erforderlichen Betriebsspannungen zu versorgen, die im allgemeinen mehrere 1000 Volt erreichen. Die Stromversorgungseinrichtung besteht in bekannter Weise aus Schaltnetzteilen, wobei die im Eingang zugeführte relativ niedrige Betriebsspannung von $U_B \approx 50$ V in Invertern in eine Wechselspannung umgeformt, durch nachfolgende Transformatoren auf einen höheren Wert transformiert und anschließend nach Gleichrichtung und Siebung den Verbraucherelektroden zur Verfügung gestellt wirdt. Die Spannungsversorgungseinrichtung enthält weiter zwei Regeleinrichtungen zur Konstanthaltung der Betriebsspannungen. Durch einen Komparator $V_1$ wird die Spannung zwiscen Helix und Kathode mit einer Referenzspannung $REF_1$ verglichen und bei Auftreten eines Fehlersignals am Ausgang des Komparators $V_1$ die Einschaltzeit der Zerhackertransformatcren des Inverters H so verändert, daß sich die transformierte und gleichgerichtete Ausgangsspannung auf den gewünschten Wert einstellt. In entsprechender Weise arbeiten die Komparatoren $V_2$ und $V_3$, welche auf die Kollektor- bzw. Anodenbetriebsspannungen einwirken. Mit Hilfe eines Umschalters S besteht die Möglichkeit, entweder die Anodenspannung oder den Kathodenstrom der Wanderfeldröhre auf konstante Amplitude zu regeln, wobei im ersten Fall die Istwertspannung über eine Meßwicklung M2 (Anodentransformator) und im anderen Fall über einen zwischen Kathode und Stromzuleitung seriell eingefügten Meßübertrager M2' gewonnen wird. Der Regler arbeitet als sogenannter Serienregler, dargestellt durch ein Transistorsymbol. Der Regelsinn des Stellgliedes für den Anodenspannungskonverter ist auf Grund der eingefügten 180-Grad-Phasendrehung dergestalt, daß eine Erhöhung der Ausgangsspannung des Komparators $V_3$ zu einer Erniedrigung der Wechselspannung im Ausgang des Inverters A führt. Erfindungsgemäß ist zwischen Inverter C und dem zugehörigen Transformator T ein Meßübertrager M1 eingefügt, durch den eine dem Kollektorstrom $I_C$ und damit der Kollektorleistung proportionale Fühlerspannung einem zusätzlichen Komparator $V_4$ zugeführt und mit einer Referenzspannung REF 4 verglichen wird. Das Komparatorausgangsseitige Fehlersignal steuert das Stellglied für den Anodeninverter A derart, daß die .aufgenommene Kollektorleistung der Wanderfeldröhre konstant gehalten wird, wenn ein bestimmter Wert überschritten wird.

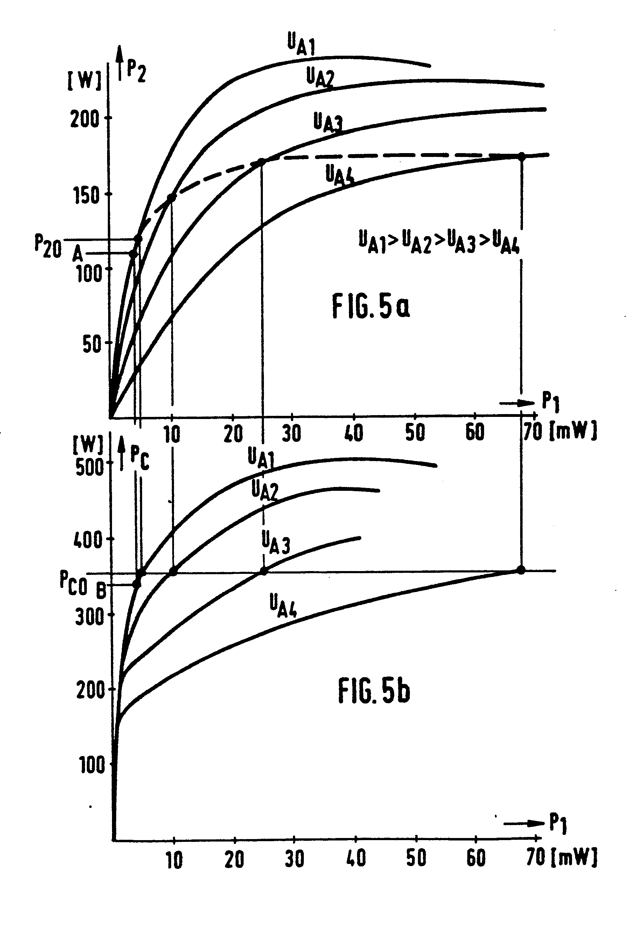

Die Wirkungsweise wird im folgenden anhand der Figuren 5a und b näher erläutert. Die Figur 5a zeigt die Übertragungskurven einer Wanderfeldröhre mit der Anodenspannung $U_A$ als Parameter. Alle Versorgungsspannungen seien im geregelten Zustand, wobei sich bei einer Steuerleistung $P_1$ der Arbeitspunkt A ergibt. Die in Figur 5b gezeichneten Kurven geben den Verlauf der aufgenommenen Kollektorleistung $P_C$ in Abhängigkeit der Steuerleistung $P_1$ wieder. Mit dem oben angegebenen Arbeitspunkt A ergibt sich die mit B bezeichnete aufgenommene Kollektorleistung, welche niedriger sei als der Wert $P_{CO}$, dem die Referenzspannung REF 4 in Figur 4 entspricht, d. h., die Ausgangsspannung des Komparators $V_4$ ist kleiner als diejenige des Komparators $V_3$. Letzterer bestimmt die Steuerspannung des Inverters A, und die Anodenspannung hat den vorbestimmten Wert $U_{A1}$.

Wird die HF-Eingangsleistung $P_1$ allmählich erhöht, so erhöht sich die aufgenommene Kollektorleistung gemäß Figur 5b. Dadurch erhöht sich auch der mittlere Strom $I_C$ in dem dem Inverter C nachgeschalteten Transformator. Übersteigt nun die aus dem Kollektorstrom $I_C$ erhaltene Fühlerspannung den Wert REF 4, welcher der Leistung $P_{CO}$ gemäß Figur 5b entspricht, so wächst die Ausgangsspannung des Komparators V4 über den Wert der Ausgangsspannung des Komparators V3, wodurch letzterer von der Regelschleife durch die an seinem Ausgang liegende sperrende Diode D3 abgekoppelt wird. Nunmehr bestimmt der Komparator V4 den Verlauf der Anodenspannung, wobei die Regelung so arbeitet, daß bei steigender Ausgangsleistung $P_1$ die Anodenspannung kleiner wird mit dem Ziel, die Kollektorleistung auf den Wert $P_{CO}$ zu begrenzen.

Den weiteren Verlauf der Übertragungscharakteristik zeigt die Figur 5a als gestrichelte Kurve, die sich aus den Schnittpunkten der Kollektorleistungs-Begrenzungskennlinie $P_{CO}$ mit den Kurvenscharen der in Abhängigkeit von der Anodenspannung ($U_{A1}$, $U_{A2}$, $U_{A3}$ und $U_{A4}$) gezeichneten Eingangsleistungs-Charakteristik in Figur 5b konstruieren läßt. Die gestrichelte Kurve gemäß Figur 5a zeigt ein ausgeprägtes Begrenzungsverhalten, dessen Einsatzpunkt $P_{20}$ durch geeignete Wahl der Referenzspannung REF 4 einstellbar ist. Da die aufgenommene Kollektorleistung $P_C$ im allgemeinen über 90 % der von einer Wanderfeldröhre aufgenommenen Gesamtleistung ist, ergibt sich damit auch eine sehr deutliche Begrezung der Gesamtleistungsaufnahme.

Selbstverständlich läßt sich die erfindungsgemäße Schaltungsanordnung nach Anspruch 2 vorteilhaft auch bei Verstärkern mit bipolaren oder Feldeffekt-Transistoren, wobei der erfaßte Versorgungsstrom der Kollektor- bzw. Drainstrom und wobei der Steuerstrom der Basis- bzw. Gatestrom sind, verwenden.

**Patentansprüche**

1. Verfahren zur automatischen Regelung der HF-Ausgangsleistung eines Hochfrequenzverstärkers mit Regelkreis, wobei eine von der HF-Ausgangsleistung abhängige Spannung gewonnen wird, aus der mit Hilfe einer Referenzspannung eine Regelspannung erzeugt wird, die zur Erzeugung einer Steuerspannung oder eines Steuerstromes, welche die Verstärkung des Verstärkers steuern, benützt wird, wobei eine von der HF-Ausgangsleistung abhängige erste Spannung aus der Versorgungsspannung oder/und aus dem Versorgungsstrom der die zur Erzeugung der HF-Leistung benötigte Leistung abgebenden Stromversorgungseinrichtung abgeleitet wird, dadurch gekennzeichnet, daß die Regelspannung aus zwei Komponenten gebildet wird, wobei die erste Komponente aus der ersten Spannung und einer ersten Referenzspannung erzeugt wird und wobei die zweite Komponente aus einer zweiten Spannung, die von der Steuerspannung oder von dem durch die Steuerspannung erzeugten Steuerstrom abhängig ist, und einer zweiten Referenzspannung erzeugt wird, daß bei großen HF-Leistungen, die den linearen Arbeitsbereich des Verstärkers überschreiten im wesentlichen nur die erste Regelkomponente wirkt und daß bei kleinen und mittleren Leistungen, deren Bereich etwa den linearen Arbeitsbereich des Verstärkers umfaßt, im wesentlichen nur die zweite Regelkomponente wirkt.

2. Schaltungsanordnung zur Durchführung des Verfahrens nach Anspruch 1, dadurch gekennzeichnet, daß ein erster Meßübertrager (M1) zur Erfassung des Versorgungsstromes ($I_C$) vorgesehen ist, dessen Ausgangsspannung gleichgerichtet und auf einen ersten Komparator (V4) geführt ist, durch den ein Vergleich mit der ersten Referenzspannung (REF 4) erfolgt, daß ein zweiter Meßübertrager (M2, M2') zur Erfassung der Steuerspannung oder des Steuerstromes vorgesehen ist, dessen Ausgangsspannung ebenfalls gleichgerichtet und einem zweiten Komparator (V3) zugeführt ist, durch den ein Vergleich mit der zweiten Referenspannung (REF 3) erfolgt, und daß die Komparatorausgänge, an denen die beiden Komponenten anstehen, über Dioden (D3, D4) voneinander entkoppelt auf einen Ausgang zusammengeführt sind, an dem die Regelspannung ansteht.

3. Schaltungsanordnung nach Anspruch 2, wobei der Verstärker ein Wanderfeldröhrenverstärker (TWTA) mit einer Mehrstufenkollektoranordnung ist und wobei die Steuerspannung die Anodenspannung für die Wanderfeldröhre ist, dadurch gekennzeichnet, daß die erste Spannung aus dem Versorgungsstrom ($I_C$) der Stromversorgungseinrichtung für einen oder mehrere Kollektoren der Mehrstufenkollektoranordnung abgeleitet wird.

4. Schaltungsanordnung nach Anspruch 3, wobei die Stromversorgungseinrichtung einen Gleichstrominverter (C) mit nachgeschaltetem Transformator und nachgeschalteter Gleichrichter- und Siebeinrichtung enthält, dadurch gekennzeichnet, daß der erste Meßübertrager (M1) zwischen Gleichstrominverter (C) und Transformator (T) in Serie eingefügt ist, so daß der mittlere Strom ($I_C$) durch die Primärwicklung des Transformators (T) erfaßt wird.

**Claims**

1. Method for the automatic regulation of the HF output power of a high frequency amplifier including a regulating circuit, wherein a voltage is obtained which is dependent upon the HF output power and from which a regulating voltage is generated with the aid of a reference voltage, said regulating voltage being used to generate a control voltage or a control current to control the gain of the amplifier, with a first voltage dependent upon the UF output power being derived from the supply voltage and/or from the supply current of the current supply device which provides the power required to generate the HF power, characterized in that the regulating voltage is formed of two components, the first component being generated from the first voltage and a first reference voltage and the second component being generated from a second voltage dependent upon the control voltage or the control current generated by the control voltage and a second reference voltage ; if the HF power is so high that it exceeds the linear operating range of the amplifier, essentially only the first regulating component is active and for small and medium power in a range approximately falling into the linear operating range of the amplifier, essentially only the second regulating component is active.

2. Circuit arrangement for implementing the method according to claim 1, characterized in that a first measuring transformer (M1) is provided to detect the supply current ($I_C$), with the output voltage of said measuring transformer being rectified and fed to a first comparator (V4) which effects a comparison with the first reference voltage (REF 4) ; a second measuring transformer (M2, M2') is provided to detect the control voltage or the control current, with the output of said second measuring transformer likewise being rectified and fed to a second comparator (V3) which effects a comparison with the second reference voltage (REF 3) ; and the comparator outputs at which the two components are present are decoupled from one another via diodes (D3, D4) and are jointly brought to an output at which the regulating voltage is present.

3. Circuit arrangement according to claim 2, wherein the amplifier is a traveling wave tube amplifier (TWTA) including a multistage collector arrangement and the control voltage is the anode voltage for the traveling wave tube, characterized in that the first voltage is derived from the supply current ($I_C$) of the current supply device for one or a plurality of collectors of the multistage collector arrangement.

4. Circuit arrangement according to claim 3, wherein the current supply device includes a direct current inverter (C) connected to a transformer followed by a rectifier and filter device, characterized in that the first measuring transformer (M1) is connected is series between the direct current inverter (C) and the transformer (T) so as to detect the center current ($I_C$) through the primary winding of the transformer.

**Revendications**

1. Procédé de régulation automatique de la puissance de sortie HF d'un amplificateur haute fréquence avec une boucle de régulation, une tension fonction de la puissance de sortie HF servant à la production, à l'aide d'une tension de référence, d'une tension de réglage qui sert à la production d'une tension ou d'un courant de commande du gain de l'amplificateur, une première tension fonction de la puissance de sortie HF étant dérivée de la tension ou/et du courant d'alimentation du dispositif d'alimentation délivrant la puissance nécessaire à la production de la puissance HF, ledit procédé étant caractérisé en ce que la tension de réglage est constituée par deux composantes, dont la première est produite à partir de la première tension et d'une première tension de référence, et dont la seconde est produite à partir d'une seconde tension, qui dépend de la tension de commande ou du courant de commande produisant cette dernière, et d'une deuxième tension de référence ; seule la première composante de régulation agit pratiquement dans le cas de fortes puissances HF supérieures au domaine de fonctionnement linéaire de l'amplificateur ; et seule la seconde composante de régulation agit pratiquement dans le cas de puissance faibles ou moyennes, dont le domaine couvre sensiblement le domaine de fonctionnement linéaire de l'amplificateur.

2. Montage pour la mise en œuvre du procédé selon revendication 1, caractérisé en ce qu'un premier transformateur de mesure (M1) est prévu pour la détection du courant d'alimentation ($I_C$), sa tension de sortie étant redressée puis appliquée à un premier comparateur ($V_4$) pour comparaison avec la première tension de référence ($REF_4$) ; un second transformateur de mesure (M2, M2') est prévu pour la détection de la tension ou du courant de commande, sa tension de sortie étant également redressée puis appliquée à un second comparateur ($V_3$) pour comparaison avec la seconde tension de référence ($REF_3$) ; et les sorties de comparateur délivrant les deux composantes sont découplées par des diodes (D3, D4) et réunies sur une sortie délivrant la tension de régulation.

3. Montage selon revendication 2, dans lequel l'amplificateur est équipé d'un tube à onde progressive (TOP) avec un collecteur étagé et la tension de commande est la tension anodique du tube à onde progressive, ledit montage étant caractérisé en ce que la première tension est dérivée du courant d'alimentation ($I_C$) du dispositif d'alimentation d'un ou plusieurs collecteurs du montage à collecteur étagé.

4. Montage selon revendication 3, dans lequel le dispositif d'alimentation comprend un inverseur de courant continu (C) avec un transformateur en aval et un dispositif de redressement-lissage en aval, ledit montage étant caractérisé en ce que le premier transformateur de mesure (M1) est inséré en série entre l'inverseur de courant continu (C) et le transformateur (T), de sorte que le courant moyen ($I_C$) est décelé par l'enroulement primaire du transformateur (T.)

Ausgangsleistung $P_2$

B

C

$\bar{A}$

D

A

E

$A^I$

$E^I$

linearer Arbeitspunkt

Eingangsleistung $P_1$

0

FIG.1

$P_1$

4

1

2

$P_2$

$U_S$

$U_F$

3

REF.

FIG.2

$P_1$

1

2

$P_2$

$U_S$

$U_F$

3

REF.

FIG.3

1

FIG.4

FIG.5a

FIG.5b